# DEMANDE DE BREVET EUROPEEN

(11) **EP 3 570 330 A1**
(43) Date de publication de la demande: **20.11.2019**
(21) Numéro de dépôt: 19174270.9
(22) Date de dépôt: 14.05.2019
(51) Int. Cl.: H01L 31/0352, H01L 21/20, H01L 31/105, H01L 31/107, H01L 31/109

(54) **PROCÉDÉ DE RÉALISATION D'UNE PHOTODIODE ET PHOTODIODE**

(30) Priorité: 16.05.2018 FR 1854086
(71) Demandeur: Commissariat à l'Energie Atomique et aux Energies Alternatives, 75015 Paris (FR)
(72) Inventeur: EL ZAMMAR, Georgio, 38054 GRENOBLE CEDEX 09 (FR); KHAZAKA, Rami, 38054 GRENOBLE CEDEX 09 (FR); MENEZO, Sylvie, 38054 GRENOBLE CEDEX 09 (FR)
(74) Mandataire: Decobert, Jean-Pascal

(57) **Abrégé**

L'invention a pour objet un procédé de réalisation d'une photodiode latérale comprenant une couche 12 surmontée par un premier motif comprenant une zone d'absorption A intercalée entre deux zones de contact 1, 2. Après encapsulation du premier motif, une cavité est formée entre les zones de contact par gravure au travers d'ouvertures, puis remplie par un matériau 3 constitutif de la zone d'absorption A par épitaxie latérale de ce matériau 3 à partir des parois latérales de la cavité 42.

Selon une possibilité, une première épitaxie latérale est réalisée pour former une zone de multiplication M, puis une deuxième épitaxie latérale est réalisée pour former une zone de charge C avant l'épitaxie latérale du matériau 3 constitutif de la zone d'absorption A, de façon à obtenir une photodiode à avalanche latérale présentant un confinement optique amélioré.

L'invention a également pour objet une photodiode latérale présentant un confinement optique amélioré.

## Description

### DOMAINE TECHNIQUE

L'invention concerne le domaine de la photonique et de l'optoélectronique. Elle trouve au moins une application particulièrement avantageuse dans le domaine des photodétecteurs. Elle trouvera pour application avantageuse mais non limitative la réalisation de photodiodes à avalanche à base de germanium.

### ÉTAT DE LA TECHNIQUE

Dans le domaine de la photonique sur silicium, un photodétecteur est un composant optoélectronique essentiel des systèmes de communication optiques intégrables en technologie CMOS.

Un enjeu lié à la fabrication des photodétecteurs est d'augmenter la sensibilité de détection de la lumière.

Un principe de détection de la lumière dans un photodétecteur ou une photodiode est le suivant :
Un photon est absorbé dans la zone d'absorption de la photodiode. L'absorption de ce photon génère une paire électron-trou. L'électron et le trou, appelés porteurs de charge électrique, peuvent être ensuite collectés via des électrodes ou des zones de contact. Le courant électrique généré par ces porteurs peut ainsi être exploité pour la détection du photon à l'origine du phénomène.

Une première architecture de photodiode exploitant ce principe est une photodiode p-i-n comprenant une zone d'absorption en un matériau non dopé (i pour intrinsèque) intercalée entre deux zones de contact en un matériau dopé (p et n pour le type de dopage correspondant).

Du fait de ses propriétés d'absorption et de conduction, et de sa compatibilité avec les technologies CMOS, le germanium (Ge) est généralement utilisé pour fabriquer des photodiodes Ge présentant une architecture classique Ge-p / Ge-i / Ge-n.

Une possibilité particulièrement intéressante pour augmenter la sensibilité de détection des photodiodes est d'améliorer le confinement des photons dans la zone d'absorption de la photodiode.

Le confinement des photons dans la zone d'absorption peut résulter d'un contraste d'indices optiques entre le matériau de la zone d'absorption et les matériaux environnants.

Le document « Développement de photodiodes à avalanche en Ge sur Si pour la détection faible signal et grande vitesse, L. Virot, Université Paris Sud - Paris XI, 2014 » divulgue par exemple une architecture de photodiode p-i-n utilisant le silicium (Si) et le germanium (Ge).

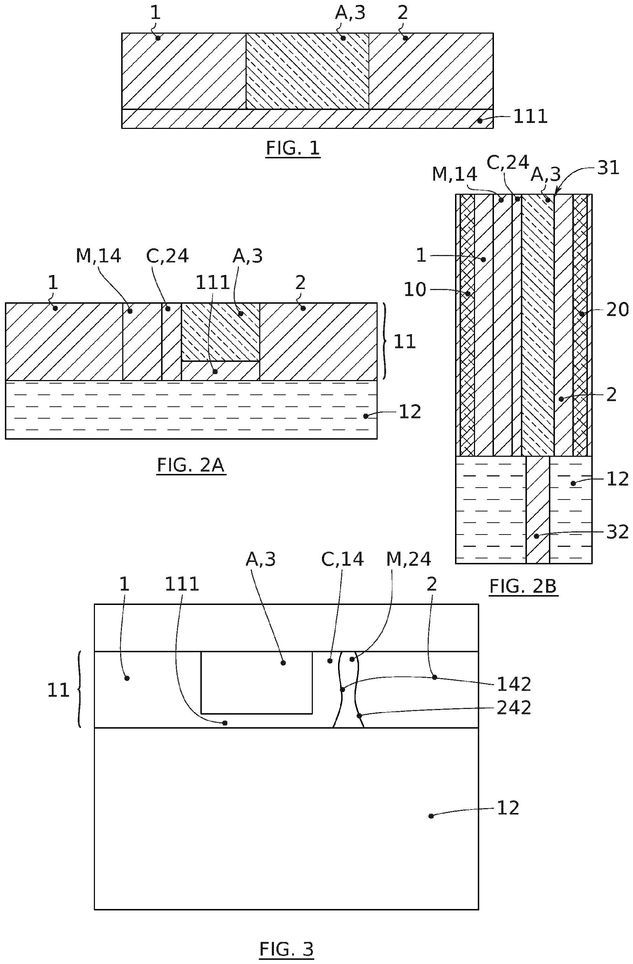

Une telle photodiode illustrée à la figure 1 présente une double hétérojonction Si-p / Ge-i / Si-n. Cette architecture permet un confinement de la lumière amélioré par rapport à une photodiode Ge classique.

La zone d'absorption A intercalée entre les zones de contact 1 et 2 de cette photodiode à double hétérojonction est formée par croissance du Ge 3 à partir d'une couche de germination 111 en Si. Ce procédé de fabrication induit des pertes optiques au niveau de la couche de germination 111 qui nuisent au confinement optique dans la zone d'absorption A.

Une autre possibilité pour augmenter la sensibilité de la détection des photodiodes est de générer plusieurs porteurs à partir d'un seul porteur initialement issu de l'absorption d'un photon, de sorte à collecter un courant significatif et mesurable. C'est le principe de multiplication des porteurs.

Une deuxième architecture de photodiode exploitant ce principe de multiplication est une photodiode à avalanche comprenant une zone d'absorption et une zone de multiplication intercalées entre deux zones de contact.

Le document cité plus haut divulgue par exemple une architecture de photodiode à avalanche s'étendant latéralement. Une telle photodiode est illustrée aux figures 2A et 2B.

Là encore, une couche de germination 111 est nécessaire à la formation de la zone d'absorption A entre la zone de multiplication M, une zone de charge C et la zone de contact 2.

Un inconvénient de ce procédé de réalisation est là encore l'apparition de pertes optiques au niveau de la couche de germination 111.

Un autre inconvénient du procédé de réalisation d'une telle photodiode est lié à la formation de la zone de charge C. Cette zone de charge C est en effet généralement obtenue par implantation ionique. Une telle implantation conduit à un profil de dopage mal défini comme illustré à la figure 3, en particulier au niveau de l'interface 142entre les zones de charge C et de multiplication M.

Un objet de la présente invention est de pallier au moins en partie certains des inconvénients mentionnés ci-dessus.

Selon un aspect particulier, un objet de la présente invention est de proposer un procédé de réalisation d'une photodiode latérale visant à optimiser le confinement optique dans la zone d'absorption de la photodiode.

Selon un autre aspect, un objet de la présente invention est de proposer une photodiode latérale visant à optimiser le confinement optique dans la zone d'absorption de la photodiode.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, un premier aspect concerne un procédé de réalisation d'une photodiode comprenant une première zone de contact, une deuxième zone de contact et une zone d'absorption juxtaposées de sorte à s'étendre parallèlement suivant une première direction, ladite zone d'absorption étant située entre les première et deuxième zones de contact selon une deuxième direction.

Ce procédé comprend les étapes suivantes :
- Fournir un premier substrat comprenant un empilement selon une troisième direction d'une première couche à base d'un premier matériau sur une deuxième couche à base d'un deuxième matériau différant du premier matériau,
- Former au niveau de la première couche la première zone de contact,
- Former au niveau de la première couche la deuxième zone de contact,
- Former au niveau de la première couche la zone d'absorption.

Avantageusement mais non limitativement, la formation de la zone d'absorption comprend au moins les étapes successives suivantes :
- Encapsuler la première couche, au moins dans une zone correspondant à la zone d'absorption, par une couche d'encapsulation,
- Former au moins une ouverture au travers de la couche d'encapsulation de sorte à exposer une zone de la première couche,
- Former une cavité au moins au niveau de la zone d'absorption, ladite formation comprenant un retrait du premier matériau sur toute l'épaisseur de la première couche au travers de l'au moins une ouverture, la cavité comprenant une face inférieure à base du deuxième matériau de la deuxième couche, une face supérieure formée par une partie de la couche d'encapsulation et une pluralité de parois latérales s'étendant selon la troisième direction, ladite pluralité comprenant au moins une paroi latérale à base du premier matériau s'étendant selon la première direction en bordure de l'une parmi les première et deuxième zones de contact,
- Remplir au travers de l'au moins une ouverture la cavité avec un troisième matériau de remplissage par une croissance épitaxiale latérale dudit matériau au moins à partir de l'au moins une paroi latérale de la cavité, la croissance étant principalement dirigée selon la deuxième direction.

Ce procédé permet avantageusement de s'affranchir d'une couche de germination sur la face inférieure de la cavité pour la croissance du matériau de remplissage. Le confinement optique dans la zone d'absorption de la photodiode peut ainsi être amélioré en supprimant les pertes optiques induites par la couche de germination.

Afin d'augmenter le confinement de la lumière dans du germanium, une solution avantageuse consiste à former la zone d'absorption en germanium directement sur un oxyde. Le contraste d'indices optiques est ainsi optimisé et le confinement des photons est amélioré. Un tel procédé se base sur un empilement de type GeOI (selon l'acronyme anglais « Germanium On Insulator »).

De façon particulièrement avantageuse, la zone d'absorption est formée par remplissage de la cavité à partir de ses parois latérales, entre les première et deuxième zones de contact d'une part, et entre la deuxième couche et la couche d'encapsulation d'autre part.

Le procédé permet donc d'assurer une continuité pour le transport électrique des porteurs de charge entre les première et deuxième zones de contact.

La disposition relative des zones de contact et d'absorption confère à la photodiode une architecture dite latérale, où les porteurs de charge générés dans la zone d'absorption sont dirigés selon la deuxième direction avant d'être collectés au niveau des zones de contact.

Le procédé permet également de réaliser localement une structure de type GeOI. Le confinement optique dans la zone d'absorption selon la troisième direction peut dès lors être amélioré par rapport à une structure Ge classique comprenant par exemple une couche de germination configurée pour faire croître le matériau de la zone d'absorption selon la troisième direction.

Une telle amélioration est avantageusement applicable à différentes architectures de photodiodes.

En particulier, ce procédé est compatible avec la réalisation de photodiodes GeOI p-i-n et/ou de photodiodes GeOI à avalanche.

Selon un mode de réalisation préféré, la pluralité de parois latérales de la cavité forme un contour fermé. Le remplissage de la cavité par croissance latérale principalement selon la deuxième direction est dès lors contraint selon la première direction. Le remplissage est ainsi mieux contrôlé.

Selon une possibilité particulièrement avantageuse mais non limitative, le procédé comprend en outre, lors de la formation de la cavité après retrait du premier matériau, les étapes suivantes :
- Former, sur au moins une paroi latérale bordant l'une au moins parmi les première et deuxième zones de contact, une première couche latérale en un matériau à base du premier matériau mais différent du premier matériau, destinée à former une couche de multiplication de la photodiode, et,
- De manière préférée mais optionnelle après formation de la première couche latérale, former, sur au moins une paroi latérale de la première couche latérale, une deuxième couche latérale à base du premier matériau mais différent du premier matériau et du matériau de la première couche latérale, destinée à former une couche de charge de la photodiode.

Selon cette possibilité, le procédé permet de former une photodiode GeOI à avalanche présentant des zones de multiplication et de charge séparées. Cette structure de photodiode est appelée SACM (acronyme de « Separate Absorption, Charge and Multiplication).

Selon un mode de réalisation avantageux, la formation de la deuxième couche latérale se fait par une croissance épitaxiale latérale principalement selon la deuxième direction. Cela permet d'obtenir une zone de charge bien définie et uniforme, contrairement aux zones de charge obtenues classiquement par implantation ionique.

Une photodiode GeOI à avalanche basée sur une telle structure SACM épitaxiée latéralement présente un fonctionnement optimisé.

Cette structure permet en effet d'obtenir une interface entre les zones de charge et de multiplication très bien définie. Dès lors, le champ électrique dans la photodiode peut varier très rapidement à cette interface. Cette variation est avantageusement plus rapide qu'une variation de champ électrique se produisant à une interface issue d'une zone de charge réalisée par implantation.

Par ailleurs, cette structure SACM épitaxiée latéralement permet d'obtenir une deuxième couche latérale à la fois fortement dopée et de faible largeur. Dès lors, le champ électrique peut être élevé dans la zone de multiplication. En particulier, le champ électrique est plus élevé dans la zone de multiplication bordant une telle deuxième couche latérale, que dans une zone de multiplication bordant une zone de charge réalisée par implantation.

La photodiode réalisée par le procédé pourra avantageusement équiper un photodétecteur dans le domaine de la photonique sur silicium.

Un aspect séparable concerne une photodiode comprenant une première zone de contact, une deuxième zone de contact et une zone d'absorption formées dans une première couche à base d'un premier matériau et juxtaposées de sorte à s'étendre parallèlement suivant une première direction, ladite zone d'absorption étant située entre les première et deuxième zones de contact selon une deuxième direction, la première couche étant au contact d'une deuxième couche à base d'un deuxième matériau différant du premier matériau, selon une troisième direction perpendiculaire aux première et deuxième directions. La zone d'absoprtion est localisée dans une cavité dans la première couche. Elle confine la lumière.

Avantageusement, la zone d'absorption est formée directement au contact du deuxième matériau de la deuxième couche, préférentiellement sur toute une épaisseur de la première couche, et comprend un troisième matériau différant des premier et deuxième matériaux.

Une telle photodiode latérale permet d'optimiser le confinement optique dans la zone d'absorption de la photodiode.

En particulier, le contraste d'indice entre les deuxième et troisième matériaux peut être avantageusement plus grand que le contraste d'indice entre les premier et troisième matériaux.

Selon une possibilité, le premier matériau est du silicium, le deuxième matériau est un matériau diélectrique tel qu'un oxyde de silicium, et le troisième matériau est du germanium.

La photodiode peut donc être avantageusement une photodiode latérale GeOI dans laquelle la zone d'absorption en Ge est directement au contact de l'oxyde de silicium de la deuxième couche sous-jacente.

Selon un mode de réalisation avantageux, la photodiode comprend en outre une zone de multiplication et une zone de charge formées sur toute une épaisseur de la première couche et intercalées entre la première zone de contact et la zone d'absorption.

La photodiode peut donc être avantageusement une photodiode latérale GeOI à avalanche.

La photodiode peut être réalisée par le procédé selon le premier aspect.

La photodiode pourra avantageusement équiper un photodétecteur dans le domaine de la photonique sur silicium.

### BRÈVE DESCRIPTION DES FIGURES

Les buts, objets, ainsi que les caractéristiques et avantages ressortiront mieux de la description détaillée de modes de réalisation de cette dernière qui sont illustrés par les dessins d'accompagnement suivants dans lesquels :
- La FIGURE 1 est une vue en coupe d'une photodiode latérale à double hétérojonction selon l'art antérieur ;
- La FIGURE 2a est un schéma en coupe d'une photodiode latérale à avalanche réalisée selon l'art antérieur ;
- La FIGURE 2b est un schéma vu de dessus d'une photodiode latérale à avalanche réalisée selon l'art antérieur ;
- La FIGURE 3 est une simulation en coupe d'une photodiode latérale à avalanche réalisée selon l'art antérieur ;
- Les FIGURES 4 à 19B illustrent des étapes de réalisation d'une photodiode selon un premier mode de réalisation de la présente invention ;
- Les FIGURES 20 à 29 illustrent des étapes de réalisation d'une photodiode selon un deuxième mode de réalisation de la présente invention ;
- Les FIGURES 30 à 39 illustrent des étapes de réalisation d'une photodiode selon un troisième mode de réalisation de la présente invention.

Les figures portant le même numéro indexées A et B illustrent une même étape de procédé respectivement en coupe transverse et en vue de dessus.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs et dimensions des différentes couches et portions des photodiodes illustrées ne sont pas représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement :
- La formation de l'au moins une ouverture est configurée de sorte à ce que la zone exposée de la première couche soit située en dehors de la zone d'absorption, de préférence à une distance supérieure à 1 µm de la zone d'absorption.
- Les premier et troisième matériaux présentent chacun une structure cristallographique de type cubique, et la première direction correspond à une orientation cristallographique de type [100], la deuxième direction correspond à une orientation cristallographique de type [010], et la troisième direction correspond à une orientation cristallographique de type [001].
- Le procédé comprend en outre, lors de la formation de la cavité après retrait du premier matériau, l'étape suivante :
   - Former par une croissance épitaxiale latérale principalement selon la deuxième direction, sur au moins une paroi latérale bordant l'une au moins parmi les première et deuxième zones de contact, une première couche latérale en un matériau à base du premier matériau mais différent du premier matériau, destinée à former une couche de multiplication de la photodiode.
- La formation de la première couche latérale se fait par une croissance épitaxiale latérale principalement selon la deuxième direction.
- Le procédé comprend en outre, après la formation de la première couche latérale, l'étape suivante :
   - Former, sur au moins une paroi latérale de l'au moins une première couche latérale, au moins une deuxième couche latérale à base du premier matériau mais différent du premier matériau et du matériau de la première couche latérale, destinée à former une couche de charge de la photodiode.
- La formation de la deuxième couche latérale se fait par une croissance épitaxiale latérale principalement selon la deuxième direction.
- Le premier substrat comprend une troisième couche, de sorte que la deuxième couche soit intercalée entre les première et troisième couches selon la troisième direction, le procédé comprenant en outre une séquence d'étapes de retournement de la photodiode sur un deuxième substrat, ladite séquence comprenant les étapes suivantes :
   - Fournir un deuxième substrat,
   - Coller par adhésion moléculaire le deuxième substrat au premier substrat selon la troisième direction, la première couche du premier substrat étant tournée en regard du deuxième substrat,
   - Retirer la troisième couche du premier substrat.
- Le procédé comprend en outre une formation au niveau de la couche supérieure d'un guide d'onde en couplage direct avec la zone d'absorption.
- L'au moins une ouverture présente un contour fermé et est distante de la première zone de contact d'une distance d selon la deuxième direction telle que 0.6 µm < d < 1.5 µm et de préférence 1.1 µm < d < 1.5 µm.
- L'au moins une paroi latérale à base du premier matériau s'étendant selon la première direction comprend une première paroi latérale et une deuxième paroi latérale en regard de la première paroi latérale, et l'au moins une ouverture est située à égale distance desdites première et deuxième parois latérales selon la deuxième direction.
- La croissance épitaxiale latérale du matériau de remplissage se fait à une première température T1 pendant un premier temps t1 tels que 400°C < T1 < 450°C et 1 min < t1 < 20 min, puis à une deuxième température T2 comprise entre 600°C et 750°C pendant un deuxième temps t2 choisi de manière à remplir toute la cavité.
- Le retrait du premier matériau lors de la formation de la cavité se fait par gravure, ladite gravure étant configurée pour produire une vitesse de gravure au moins 25 % plus grande dans des directions cristallographiques [110] et [1-10] que dans des directions cristallographiques [010] et [100] du premier matériau de la première couche, et de préférence au moins 35 % plus grande.
- Le premier matériau est du silicium, le deuxième matériau est un matériau diélectrique tel qu'un oxyde de silicium, et le troisième matériau est du germanium.
- Le procédé comprend en outre une formation d'une cavité supplémentaire juxtaposée à la cavité et s'étendant parallèlement à celle-ci selon la première direction, ladite formation comprenant les étapes suivantes :
   - Encapsuler la première couche, au moins dans une zone juxtaposant la cavité, par une couche d'encapsulation,
   - Former au moins une ouverture supplémentaire au travers de la couche d'encapsulation de sorte à exposer une zone de la première couche au niveau de la zone juxtaposant la cavité,
   - Retirer le premier matériau sur toute l'épaisseur de la première couche au travers de l'au moins une ouverture supplémentaire,
      ladite cavité supplémentaire comprenant une face inférieure à base du deuxième matériau de la deuxième couche, une face supérieure formée par une partie de la couche d'encapsulation et une pluralité de parois latérales s'étendant selon la troisième direction, ladite pluralité comprenant au moins une paroi latérale à base du premier matériau s'étendant selon la première direction en bordure de la cavité.
- La cavité supplémentaire est formée après remplissage de la cavité.
- La formation de la cavité supplémentaire est configurée de sorte à ce que ladite cavité supplémentaire soit séparée de la cavité selon la deuxième direction par une couche à base du premier matériau présentant une dimension selon ladite deuxième direction inférieure ou égale à 50 nm.
- Le procédé comprend en outre, après formation de la cavité supplémentaire, un remplissage de ladite cavité supplémentaire au travers de l'au moins une ouverture supplémentaire avec le troisième matériau de remplissage par une croissance épitaxiale latérale dudit matériau au moins à partir de l'au moins une paroi latérale de la cavité supplémentaire, la croissance étant principalement dirigée selon la deuxième direction.
- La formation de l'une parmi les première et deuxième zones de contact se fait par implantation ionique en partie au moins au niveau de la cavité supplémentaire après remplissage de celle-ci.

L'invention selon son deuxième aspect comprend notamment les caractéristiques optionnelles ci-après pouvant être utilisées en association ou alternativement :
- La photodiode comprend en outre une zone de multiplication formée sur toute une épaisseur de la première couche et intercalée entre la première zone de contact et la zone d'absorption.
- La photodiode comprenant en outre une zone de charge formée sur toute une épaisseur de la première couche et intercalée entre la zone de multiplication et la zone d'absorption.
- la zone de multiplication (M) est configurée pour former une base de croissance latérale de la zone de charge (C).
- Les zones de charge et de multiplication présentent entre elles une interface plane.

Une telle interface plane permet au champ électrique se développant dans la photodiode de varier très rapidement au niveau de cette interface entre les zones de charge et de multiplication. Dès lors, l'ionisation par impact résultant du champ électrique commence à se produire très près d'une telle interface, dans la couche de multiplication. L'efficacité de la couche de multiplication est avantageusement augmentée. Une telle interface plane permet également de réduire la largeur de la zone de charge.
- Le premier matériau est du silicium, le deuxième matériau est un matériau diélectrique tel qu'un oxyde de silicium, et le troisième matériau est du germanium.
- Le contraste d'indice entre les deuxième et troisième matériaux est supérieur au contraste d'indice entre les premier et troisième matériaux.

Dans la suite, la photodiode à avalanche présente de préférence une configuration dite SAM ou SACM. Ces configurations sont notamment basées sur une séparation S des zones d'absorption A, de charge C et de multiplication M.

Une zone d'absorption est une zone configurée pour absorber en partie au moins les photons d'un flux lumineux incident et générer en réponse des porteurs de charges électriques, ladite génération de charges résultant du phénomène d'absorption. La zone d'absorption est de préférence en germanium dans la présente demande.

Une zone de multiplication est une zone configurée pour multiplier les charges électriques générées dans la zone d'absorption. Cette multiplication peut se faire par ionisation par impact des atomes de la zone de multiplication. Cette ionisation par impact peut être déclenchée et assistée par une forte tension de polarisation au sein de ladite zone de multiplication. La zone de multiplication est de préférence en silicium intrinsèque dans la présente demande.

Une zone de charge est une zone configurée pour écranter vis-à-vis de la zone d'absorption un champ électrique se développant dans la zone de multiplication. Cette zone de charge a pour fonction de réduire au niveau de la zone d'absorption la vitesse des charges accélérées par ledit champ électrique en direction de la zone de multiplication. La zone de charge est de préférence en silicium dopé p+ dans la présente demande.

Il est précisé que, dans le cadre de la présente invention, la disposition relative d'une troisième zone intercalée entre une première zone et une deuxième zone, ne signifie pas obligatoirement que les zones sont directement au contact les unes des autres, mais signifie que la première zone est soit directement au contact des première et deuxième zones, soit séparée de celles-ci par au moins une autre zone ou au moins un autre élément.

Les étapes de formation des zones, notamment celles de contact et celle d'absorption s'entendent au sens large : elles peuvent être réalisées en plusieurs sous-étapes qui ne sont pas forcément strictement successives.

Dans la présente invention des types de dopage sont indiqués. Ces dopages sont des exemples non limitatifs. L'invention couvre tous les modes de réalisation dans lesquels les dopages sont inversés. Ainsi, si un exemple de réalisation mentionne pour une première zone un dopage p et pour une deuxième zone un dopage n, la présente description décrit alors, implicitement au moins, l'exemple inverse dans lequel la première zone présente un dopage n et la deuxième zone un dopage p.

Les gammes de dopage associées aux différents types de dopage indiqués dans la présente demande sont les suivantes :
- dopage p++ ou n++ : supérieur à 1 x 10²⁰cm⁻³
- dopage p+ ou n+ : 1 x 10¹⁸ cm⁻³ à 9 x 10¹⁹ cm⁻³
- dopage p ou n : 1 x 10¹⁷ cm⁻³ à 1 x 10¹⁸ cm⁻³
- dopage intrinsèque : 1.10¹⁵ cm⁻³ à 1.10¹⁷ cm⁻³

Dans la suite, les abréviations suivantes relatives à un matériau M sont éventuellement utilisées :
M-i réfère au matériau M intrinsèque ou non intentionnellement dopé, selon la terminologie habituellement utilisée dans le domaine de la microélectronique pour le suffixe -i.
M-n réfère au matériau M dopé n, n+ ou n++, selon la terminologie habituellement utilisée dans le domaine de la microélectronique pour le suffixe -n.
M-p réfère au matériau M dopé p, p+ ou p++, selon la terminologie habituellement utilisée dans le domaine de la microélectronique pour le suffixe -p.

On entend par un substrat, un film, une couche, « à base » d'un matériau M, un substrat, un film, une couche comprenant ce matériau M uniquement ou ce matériau M et éventuellement d'autres matériaux, par exemple des éléments d'alliage, des impuretés ou des éléments dopants. Ainsi, une couche en un matériau à base de germanium (Ge) peut par exemple être une couche de germanium (Ge ou Ge-i) ou une couche de germanium dopé (Ge-p, Ge-n) ou encore une couche de silicium-germanium (SiGe). Une couche en un matériau à base de silicium (Si) peut par exemple être une couche de silicium (Si ou Si-i) ou une couche de silicium dopé (Si-p, Si-n).

Dans la présente demande de brevet, les première, deuxième et troisième directions correspondent respectivement aux directions portées par les axes x, y, z d'un repère de préférence orthonormé. Ce repère est représenté sur les figures annexées à la présente demande de brevet.

Dans la suite, la longueur est prise selon la première direction x, la largeur est prise selon la deuxième direction y, et l'épaisseur est prise selon la troisième direction z.

On entend par « latérale » selon les cas : une orientation des parois ou des couches normale à y, une croissance par épitaxie dirigée selon y, une disposition selon y des différentes zones actives ou éléments de la photodiode relativement les uns aux autres.

Pour déterminer la géométrie des interfaces entre les différentes zones dopées et non dopées ou intrinsèques, on peut procéder à des analyses de Microscopie Electronique à Balayage (MEB) ou de Microscopie Electronique en Transmission (MET ou TEM pour l'acronyme anglais de « Transmission Electron Microscopy »). Une croissance épitaxiale d'un matériau sur un autre produit une interface bien définie et sensiblement plane entre ces matériaux. A contrario, une implantation d'éléments dans une zone formant une interface avec une autre zone produit une interface mal définie et potentiellement non plane entre ces zones. La figure 3 montre de telles interfaces mal définies issues d'un résultat de simulation d'implantation ionique par des méthodes de type Monte Carlo. Les logiciels TRIM et SRIM par exemple permettent de mettre en oeuvre ces méthodes et d'obtenir ces résultats. D'autres méthodes, par exemple des méthodes d'éléments finis (FEM pour l'acronyme anglais Finite Elments Method) peuvent également permettre d'obtenir ces résultats.

Les compositions chimiques des différentes zones peuvent être déterminées à l'aide des méthodes suivantes bien connues telles que :
- EDX ou X-EDS acronyme de « energy dispersive x-ray spectroscopy » qui signifie « analyse dispersive en énergie de photons X ».

Cette méthode est bien adaptée pour analyser la composition de dispositifs de petites tailles telles que des photodiodes à avalanche comprenant une zone de multiplication et éventuellement une zone de charge de faibles épaisseurs. Elle peut être mise en oeuvre sur des coupes métallurgiques au sein d'un Microscope Electronique à Balayage (MEB) ou sur des lames minces au sein d'un Microscope Electronique en Transmission (MET).
- SIMS, acronyme de « Secondary Ion Mass Spectroscopy » qui signifie « Spectroscopie de Masse à Ionisation Secondaire ».
- ToF-SIMS, acronyme de « Time of Flight Secondary Ion Mass Spectroscopy » qui signifie « Spectroscopie de Masse à Ionisation Secondaire à temps de vol ».
Ces méthodes permettent d'accéder à la composition élémentaire des zones.

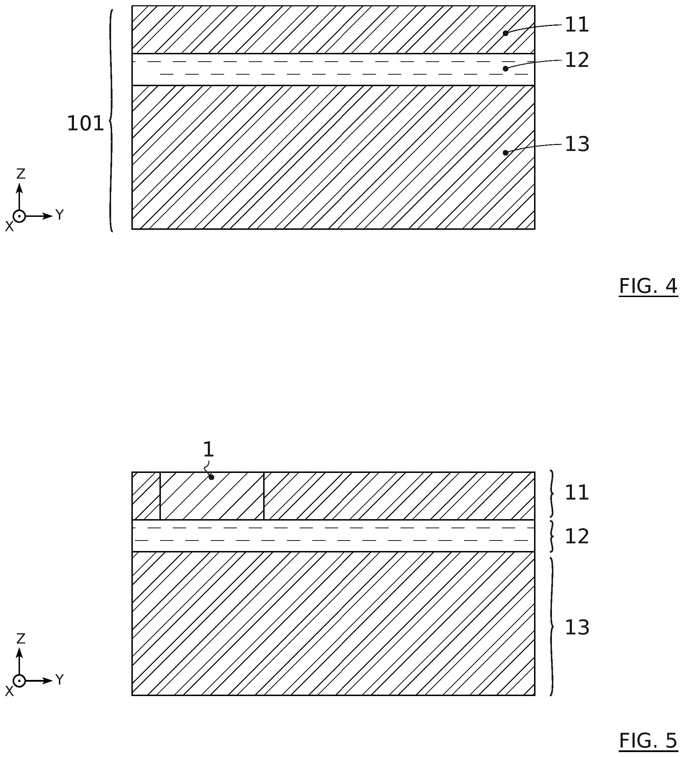

Un premier mode de réalisation du procédé selon l'invention va maintenant être décrit en référence aux figures 4 à 19B. La photodiode obtenue par ce premier mode de réalisation est une photodiode à avalanche latérale comprenant différentes zones intercalées selon y entre une première zone de contact 1 et une deuxième zone de contact 2. Ces différentes zones comprennent de préférence une zone de multiplication M, une zone de charge C et une zone d'absorption A.

Une première étape consiste à fournir un substrat 101 (figure 4) de préférence SOI (acronyme de « Silicon On Insulator » signifiant silicium sur isolant; mais des matériaux autres que le silicium sont aussi possibles). La première couche 11 en silicium, également dénommée top Si (signifiant silicium supérieur) dans la suite, présente de préférence une épaisseur comprise entre 100 nm et 700 nm, de préférence sensiblement égale à 300 nm. La deuxième couche 12 en dioxyde de silicium, également dénommée BOX (acronyme de « Burried Oxide » signifiant oxyde enterré) présente de préférence une épaisseur comprise entre 10 nm et 100 nm, de préférence sensiblement égale à 20 nm. La troisième couche 13 est en silicium et peut être également dénommée Si bulk (signifiant silicium massif) dans la suite.

Ce substrat peut présenter un diamètre de 200mm ou 300mm.

L'étape suivante consiste à former au niveau de la première couche 11 la première zone de contact 1, de préférence par implantation ionique (figure 5). Cette première zone de contact 1 peut être dopée n++ et présenter une concentration de dopants comprise entre 1 à 3 x 10¹⁹ cm⁻³. Elle peut présenter une largeur de l'ordre de 15 µm.

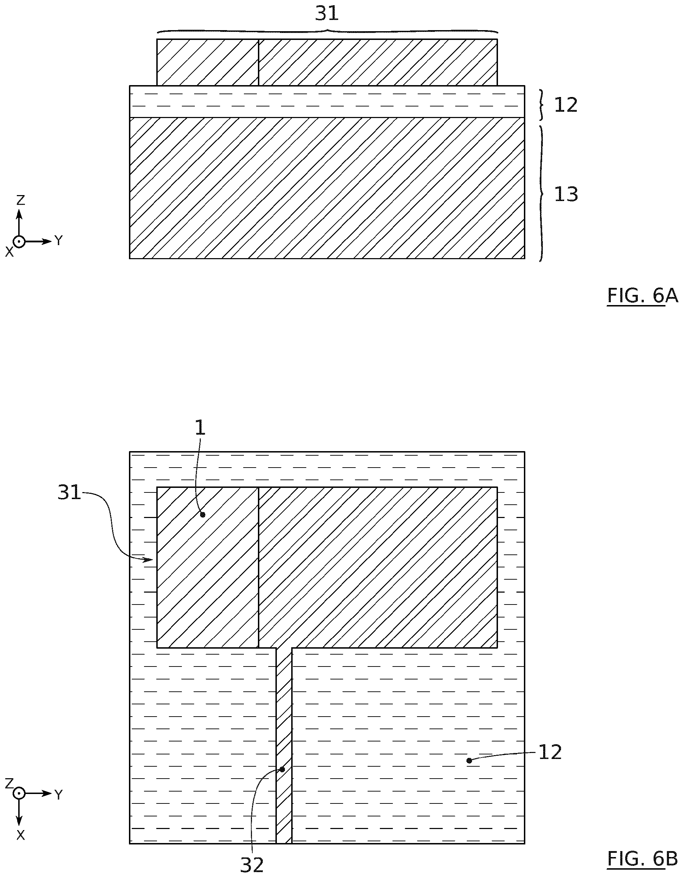

Une étape de définition d'un premier motif 31 comprenant la première zone de contact 1, la zone d'absorption A et la deuxième zone de contact 2 est de préférence effectuée par lithographie et gravure sélective du top Si sur toute sa hauteur (figure 6A). La gravure sélective du top Si 11 par rapport au BOX 12 en dioxyde de silicium est largement connue et n'est pas caractéristique de la présente invention.

La définition d'un deuxième motif en forme de guide d'onde 32 est également effectuée par lithographie et gravure sélective du top Si sur toute sa hauteur (figure 6B), de préférence lors de la définition du premier motif 31.

Ce guide d'onde 32 est de préférence configuré pour coopérer avec la zone d'absorption A par couplage direct. Le guide d'onde 32 présente de préférence une continuité avec la zone d'absorption A du premier motif 31.

Le guide d'onde 32 peut être centré ou non sur la zone d'absorption A. Il peut présenter une largeur comprise entre 300 nm et 600 nm, de préférence de l'ordre de 400 nm. Sa hauteur peut être égale à celle du top Si 11.

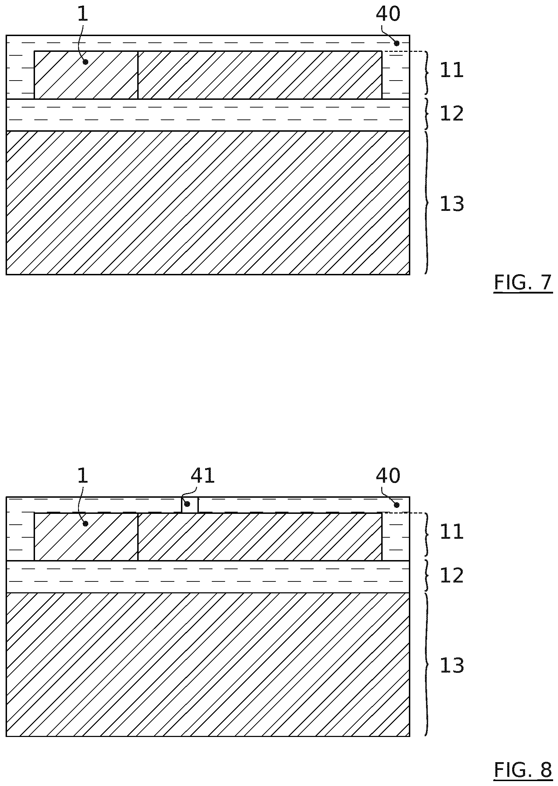

Une étape d'encapsulation est ensuite effectuée de sorte à recouvrir les premier et deuxième motifs 31, 32 par une couche d'encapsulation 40 (figure 7).

La couche d'encapsulation 40 peut être déposée par une méthode de dépôt chimique en phase vapeur (CVD) et est de préférence conforme. La couche d'encapsulation 40 présente de préférence une épaisseur comprise entre 50nm et 150nm. Elle peut être une couche d'oxyde, par exemple une couche de dioxyde de silicium.

Après encapsulation, une ou des ouvertures 41 sont formées au travers de la couche d'encapsulation 40 selon toute son épaisseur de sorte à exposer des zones du top Si 11 (figure 8). Ces ouvertures 41 peuvent être formées à l'issue d'étapes classiques de lithographie/gravure. Les ouvertures 41 présentent de préférence une section circulaire ayant un diamètre compris entre 50 nm et 200 nm, de préférence de l'ordre de 100 nm. Plus généralement, la plus grande dimension en section dans le plan xy des ouvertures 41 est de préférence inférieure ou égale à 200nm et/ou supérieure ou égale à 50nm.

Ces ouvertures 41 sont de préférence situées à une distance d selon y de la première zone de contact 1 telle que 0.6 µm < d ≤ 1.5 µm et de préférence d ≈ 1,5 µm. Cela permet d'éloigner les ouvertures 41 de la première zone de contact 1. Les ouvertures constituent en effet des singularités qui peuvent engendrer certains aléas lors des étapes suivantes de procédé, en particulier lors du remplissage d'une cavité 42 formée après ouverture de la couche d'encapsulation 40. Dès lors, il est avantageux de former les ouvertures 41 le plus loin possible de la première zone de contact 1 et/ou de la zone d'absorption A, de manière à ce que le passage des charges électriques et/ou du flux lumineux ne soit pas perturbé par les singularités formées par ces ouvertures 41.

Les ouvertures 41 sont de préférence régulièrement espacées entre elles selon x, par exemple d'une distance D ≤ 2d.

Selon une possibilité avantageuse, le positionnement des ouvertures 41 est choisi de sorte à ce que la cavité 42 présente une section rectangulaire dans le plan xy avant remplissage de ladite cavité 42 par le matériau de remplissage 3.

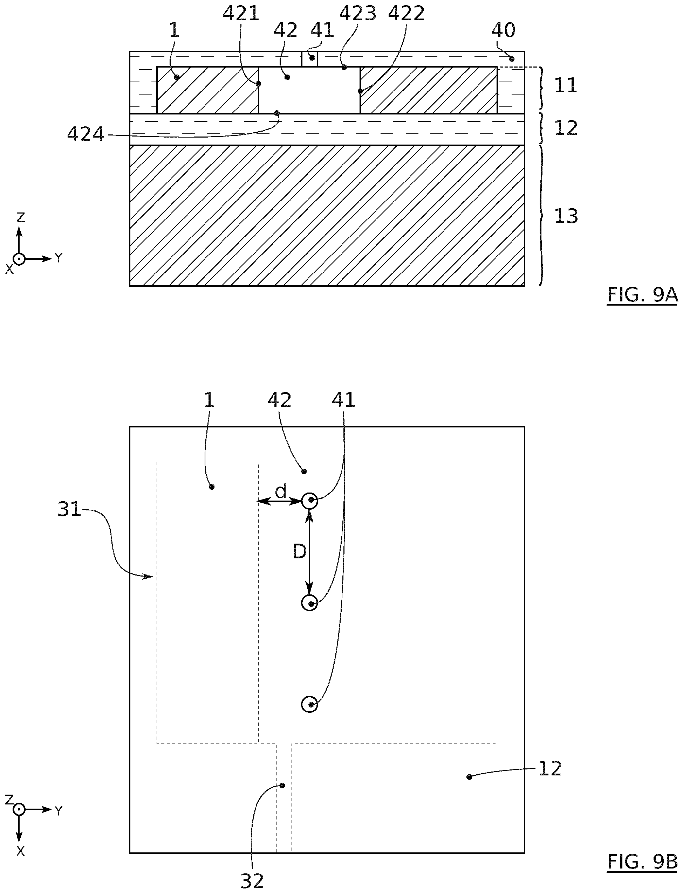

Après ouverture de la couche d'encapsulation 40, une étape de gravure du top Si 11 sélectivement au dioxyde de silicium de la couche d'encapsulation 40 et du BOX 12 est réalisée au travers des ouvertures 41, de sorte à former des alvéoles sous-jacentes aux ouvertures 41 (figure 9A).

Une alvéole correspond à une ouverture 41 au moins au début de la gravure. Les alvéoles sont de préférence centrées sur les ouvertures 41 correspondantes.

Ces alvéoles peuvent avantageusement présenter un recouvrement entre elles de sorte à former la cavité 42 en fin de gravure, tel qu'illustré en vue de dessus à la figure 9B.

Cette cavité 42 peut donc être éventuellement issue de plusieurs alvéoles agrégées.

La cavité 42 présente de préférence une largeur de l'ordre de 3 µm, une longueur comprise entre 10 µm et 20 µm en fonction du nombre d'ouvertures 41 et une hauteur sensiblement égale à la hauteur du top Si 11.

La gravure est ici configurée pour produire des alvéoles et, par suite, la cavité 42 de forme et d'orientation contrôlées.

Selon z, les alvéoles s'étendent avantageusement sur toute la hauteur du top Si, entre une face inférieure 424 formée par une partie exposée du BOX 12 et une face supérieure 423 formée par une partie exposée de la couche d'encapsulation 40.

Selon x et y, les alvéoles s'étendent de préférence selon une section sensiblement carrée dans le plan xy, les côtés du carré étant alignés selon x et y.

Dans le cas de la gravure du top Si 11, et plus généralement pour des matériaux présentant une structure cristallographique de type cubique faces centrées ou zinc blende, une telle forme carrée peut être avantageusement obtenue par une gravure anisotrope.

Une telle gravure anisotrope est notamment plus rapide dans les plans les plus denses du cristal.

Selon un mode de réalisation, la gravure, sèche ou humide, est configurée pour obtenir une vitesse de gravure dans les directions cristallographiques [110] et [1-10], supérieure d'au moins 25 %, et de préférence d'au moins 35 %, à la vitesse de gravure dans les directions [010] et [100].

Les directions des vitesses les plus grandes vont définir les diagonales d'un carré, aux tolérances de réalisation près. De ce fait, les côtés du carré sont orientés suivant la direction cristallographique [100] ou perpendiculairement à cette direction.

Les côtés de chaque cavité 42 selon x et y s'étendent donc préférentiellement respectivement selon les directions cristallographiques [100] et [010].

Dans le cas de la gravure du top Si 11, une gravure chimique utilisant un flux de vapeur d'acide chlorhydrique HCl à une température inférieure à 850°C, et de préférence inférieure à 820°C peut être avantageusement mise en oeuvre. La pression dans la chambre de gravure peut être comprise entre 10 Torr et la pression atmosphérique, et de préférence égale à 80 Torr. Le flux de HCl délivré peut être compris entre 1 slm et 25 slm (slm est l'acronyme de « standard liter per minute » en anglais, pour litres normaux par minute), et de préférence 15 slm. Un flux de H2 peut aussi être ajouté, par exemple entre quelques 1 slm et 40 slm de préférence 20 slm.

Ces conditions de gravure permettent de préférence de limiter le régime de gravure par réaction de surface, de façon à produire une gravure anisotrope du top Si 11.

Suivant une autre possibilité, la gravure est une gravure humide au travers des ouvertures 41. Dans le cas du top Si 11, une solution de préférence aqueuse et comprenant de l'hydroxyde de potassium peut être utilisée. La gravure humide, appliquée à un espace confiné, permet d'obtenir des vitesses de gravure différentes selon les directions cristallographiques.

Lors de la gravure, les première et deuxième parois latérales parallèles à x de chacune des alvéoles progressent respectivement en direction des première et deuxième zones de contact 1, 2, tandis que les troisième et/ou quatrième parois latérales de deux alvéoles adjacentes progressent les unes vers les autres.

Le temps de gravure est de préférence choisi de manière à ce que les alvéoles issues de chaque ouverture 41 se rejoignent entre elles de sorte à former une cavité 42 en fin de gravure.

La gravure est de préférence configurée pour que la paroi latérale 421 selon x de la cavité 42 corresponde à un bord de la première zone de contact 1.

En particulier, le temps de gravure peut être contrôlé de manière à arrêter la gravure du top Si 11 lorsque le front de gravure progressant selon y en direction de la première zone de contact 1 atteint le bord de cette première zone de contact 1. Selon une possibilité préférée, la gravure est arrêtée après avoir atteint le bord de la zone initialement implantée pour former la zone de contact 1. La paroi latérale 421 définissant le bord de la première zone de contact 1 est dès lors située après gravure à l'intérieur de la zone initialement implantée.

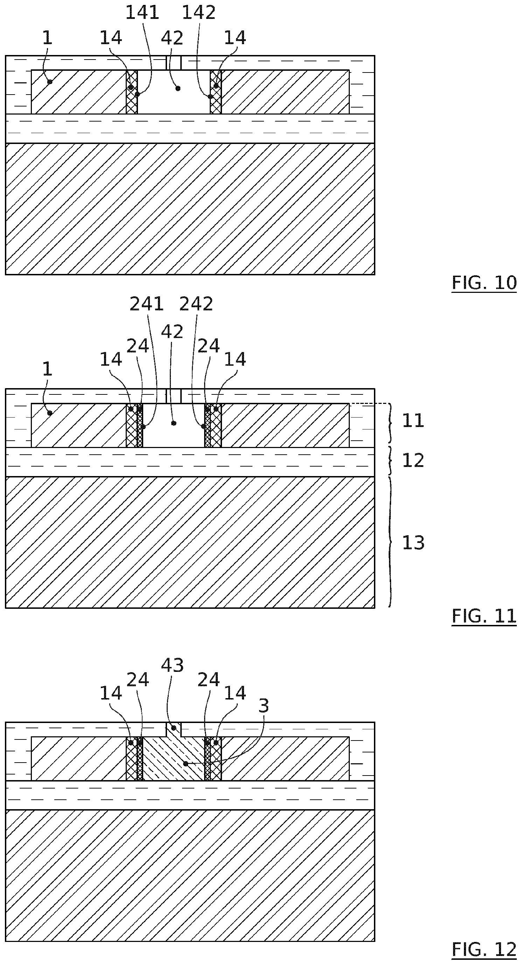

Selon ce premier mode de réalisation visant à obtenir une photodiode à avalanche, une première épitaxie latérale de silicium intrinsèque est effectuée de sorte à former une première couche 14 sur les parois latérales 421, 422 de la cavité 42 (figure 10). Cette première couche 14 correspond de préférence à la zone de multiplication M de la photodiode à avalanche. Elle peut présenter des dimensions en longueur et hauteur égales à celles de la cavité 42, et une largeur comprise entre 100 nm et 200 nm.

A l'issue de cette première épitaxie, la largeur de la cavité 42 se trouve ainsi réduite. Les parois latérales 421, 422 de la cavité 42 correspondent dès lors aux faces exposées 141, 142 de la première couche 14 épitaxiée.

De façon préférée mais optionnelle, une deuxième épitaxie latérale de silicium dopé Si-p est effectuée de sorte à former une deuxième couche 24 sur les parois latérales 421, 422 de la cavité 42, c'est-à-dire sur les faces exposées 141, 142 de la première couche 14 (figure 11). Cette deuxième couche 24 correspond de préférence à la zone de charge C de la photodiode à avalanche. Elle peut présenter des dimensions en longueur et hauteur égales à celles de la cavité 42, et une largeur comprise entre 20 nm et 100 nm. Le dopage de cette deuxième couche 24 peut être compris entre 10¹⁷ cm⁻³ et 10¹⁸ cm⁻³ environ. Pour une largeur de 30 nm par exemple, le dopage est de préférence sensiblement égal à 10¹⁸ cm⁻³. Pour une largeur de 100 nm par exemple, le dopage est de préférence sensiblement égal à 10¹⁷ cm⁻³.

Une telle zone de charge C obtenue par épitaxie latérale présente avantageusement une largeur et un dopage uniformes et très bien contrôlés, contrairement à une zone de charge obtenue par implantation ionique par exemple.

A l'issue de cette deuxième épitaxie, la largeur de la cavité 42 se trouve encore réduite. Les parois latérales 421, 422 de la cavité 42 correspondent dès lors aux faces exposées 241, 242 de la deuxième couche 24 épitaxiée.

Selon une possibilité avantageuse pour les modes de réalisation visant à obtenir une photodiode à avalanche, l'ouverture 41 à proximité immédiate du guide d'onde 32 est positionnée selon x de sorte à ce que le front de gravure progressant selon x en direction du guide d'onde 32 s'arrête dans le guide d'onde 32. Un retrait de matière selon x au niveau du guide d'onde 32 est ainsi obtenu après gravure du top Si 11, de sorte à tenir compte d'un ajout de matière lors des première et/ou deuxième épitaxies de Si-i et Si-p au niveau de ce guide d'onde 32. Ce positionnement de l'ouverture 41 à proximité du guide d'onde 32 est ainsi avantageusement choisi de sorte à ce que l'unique grande cavité présente une section rectangulaire dans le plan xy après les première et/ou deuxième épitaxies de Si-i et Si-p. L'ouverture 41 à proximité immédiate du guide d'onde 32 est également positionnée selon y à la distance d de sorte à ce que les première et/ou deuxième couches 14, 24 croissant à partir du guide d'onde 32 et de la première zone de contact 1 se rejoignent pour former un angle de la cavité 42.

La cavité 42 est ensuite remplie par épitaxie latérale de germanium 3 de sorte à former la zone d'absorption A de la photodiode (figure 12).

Le germanium 3 est ainsi avantageusement épitaxié sur les parois latérales 421, 422 à base de silicium de la cavité 42.

Cette épitaxie est de préférence réalisée à partir d'une chimie basée sur un précurseur germane GeH₄ en phase gazeuse. Un ajout d'acide chlorhydrique HCl en phase gazeuse peut avantageusement permettre d'éviter un trop fort encrassement des parois de la chambre du bâti d'épitaxie lors de l'épitaxie.

L'épitaxie latérale de germanium est de préférence réalisée en deux temps à une première température « basse » puis à une deuxième température « haute ». La première température « basse » permet de réduire les défauts d'épitaxie, et la deuxième température « haute » permet de bénéficier de vitesses de croissance élevées compatibles avec un remplissage d'une cavité de grandes dimensions. Une telle température « haute » permet également de répartir plus uniformément les dislocations présentes au sein du germanium épitaxié grâce à une plus grande mobilité desdites dislocations, et de minimiser potentiellement leur densité par recombinaison/annihilation de dislocations.

Par exemple, l'épitaxie latérale de germanium peut être effectuée à une température « basse » de l'ordre de 400°C et à une pression de l'ordre de 100 Torr pendant une durée comprise entre 5 min et 15 min, puis à une température « haute » de l'ordre de 600°C à 700°C et à une pression de l'ordre de 20 Torr pendant une durée comprise entre 5 min et 60 min.

L'épitaxie latérale de germanium peut être avantageusement poursuivie jusqu'à ce que le germanium 3 remplisse au moins partiellement les ouvertures 41.

La gravure du top Si 11, les première et deuxième épitaxies de Si-i et Si-p, ainsi que l'épitaxie de germanium peuvent se faire avantageusement dans le même bâti, de sorte à éviter une oxydation des parois latérales 421, 422 avant chaque épitaxie.

Après remplissage de la cavité 42 par épitaxie latérale du germanium, une étape de cyclage thermique optionnelle, sous H₂ à des températures variant entre 750°C et 890°C sur des cycles courts de quelques minutes peut avantageusement permettre de réduire la densité de dislocations dans le germanium 3.

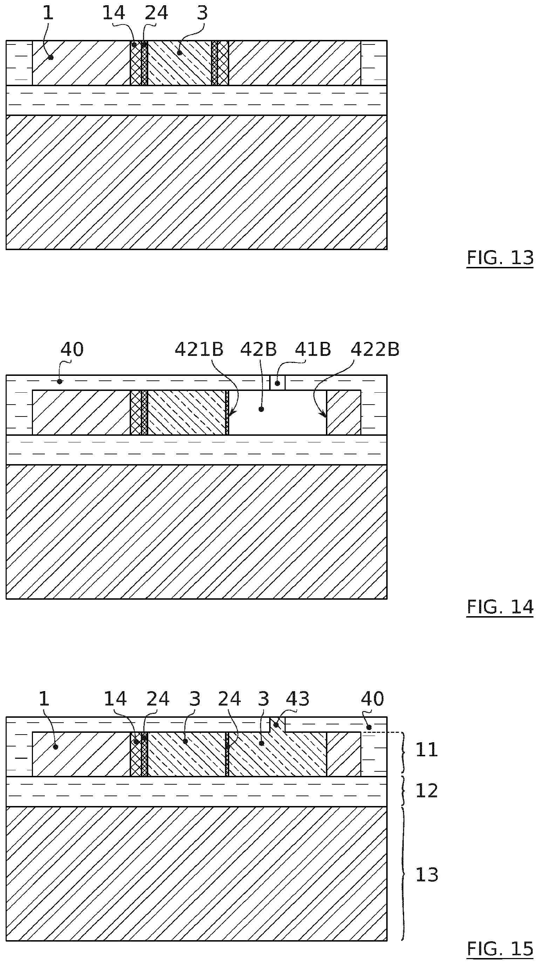

De façon optionnelle, une étape de planarisation comprenant par exemple une gravure anisotrope de la couche d'encapsulation 40 et un polissage mécano-chimique (CMP) jusqu'au top Si 11 peut être effectuée de sorte à retirer une excroissance 43 du germanium au niveau des ouvertures 41 (figure 13). Le confinement de la lumière dans le germanium est en effet modifié en fonction de la présence ou non de cette excroissance 43.

Selon ce premier mode de réalisation, une cavité supplémentaire 42b est formée au bord de la cavité 42 remplie par le germanium 3, sur un côté parallèle à x et opposé à la première zone de contact 1 (figure 14).

Cette cavité supplémentaire 42b est de préférence formée selon les mêmes modalités de formation que celles utilisées pour la formation de la cavité 42 exposées plus haut.

La cavité supplémentaire 42b présente des parois latérales 421b, 422b selon x situées sensiblement à égale distance des ouvertures 41b.

Le positionnement des ouvertures 41b et les paramètres de gravure du top Si 11 sont de préférence choisis de sorte à ce que la paroi latérale 421b de cette cavité supplémentaire 42b jouxtant la cavité 42 soit à base du matériau de la deuxième couche latérale 24. L'arrêt de la gravure est en particulier configuré pour que la deuxième couche 24 présente une largeur résiduelle comprise entre 20 nm et 50 nm (figure 14). Cette deuxième couche 24 résiduelle en Si-p peut ainsi avantageusement servir de germe présentant une bonne qualité cristalline pour l'étape suivante.

L'étape suivante consiste à remplir la cavité supplémentaire 42b par épitaxie latérale de germanium (figure 15). Ce remplissage est réalisé de préférence selon les mêmes conditions de remplissage que celles utilisées pour le remplissage de la cavité 42 exposées plus haut.

Une étape de planarisation comprenant par exemple une gravure anisotrope de la couche d'encapsulation 40b et un polissage mécano-chimique (CMP) jusqu'au top Si 11 est de préférence effectuée.

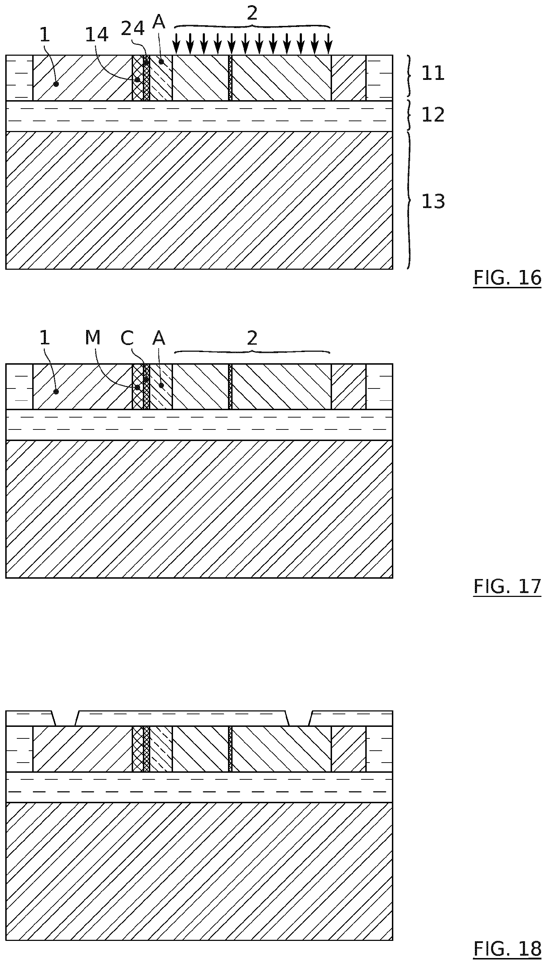

La deuxième zone de contact 2 peut ensuite être formée par implantation ionique du germanium au moins au niveau de la cavité supplémentaire 42b préalablement remplie, et de préférence en partie au niveau de la cavité 42 préalablement remplie (figure 16). Cette deuxième zone de contact 2 peut être dopée p++ et présenter une concentration de dopants comprise entre 1 à 3 x 10¹⁹ cm⁻³.

Cette deuxième zone de contact 2 est de préférence définie de manière à obtenir selon y une succession continue des zones suivantes :
La première zone de contact 1, puis la zone de multiplication M, puis la zone de charge C, puis la zone d'absorption A, puis la deuxième zone de contact 2 de sorte à former latéralement une photodiode à avalanche SACM (figure 17).

La largeur de la deuxième zone de contact 2 est choisie de manière à ce que la zone d'absorption A présente une largeur comprise entre 400 nm et 700 nm, de préférence de l'ordre de 600 nm. Par exemple, la largeur de la deuxième zone de contact 2 peut être comprise entre 4 µm et 5 µm.

Les étapes suivantes peuvent être des étapes classiques de formation des contacts métalliques, comprenant notamment le dépôt d'une couche diélectrique, de préférence en SiO2, la formation de vias traversants au niveau des première et deuxième zones de contact 1, 2 (figure 18), le dépôt des contacts métalliques 10, 20 dans les vias et d'éventuels recuits thermiques rapides (RTA de l'acronyme anglais « Rapid Thermal Annealing ») pour l'activation des contacts 10, 20.

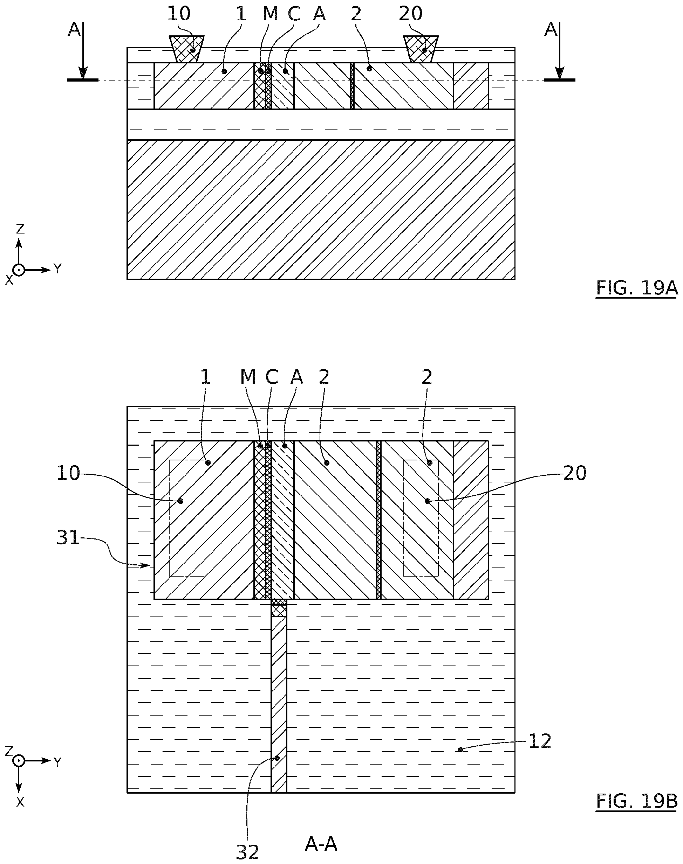

Une photodiode à avalanche latérale GeOI à simple hétérojonction est ainsi avantageusement obtenue (figures 19A et 19B).

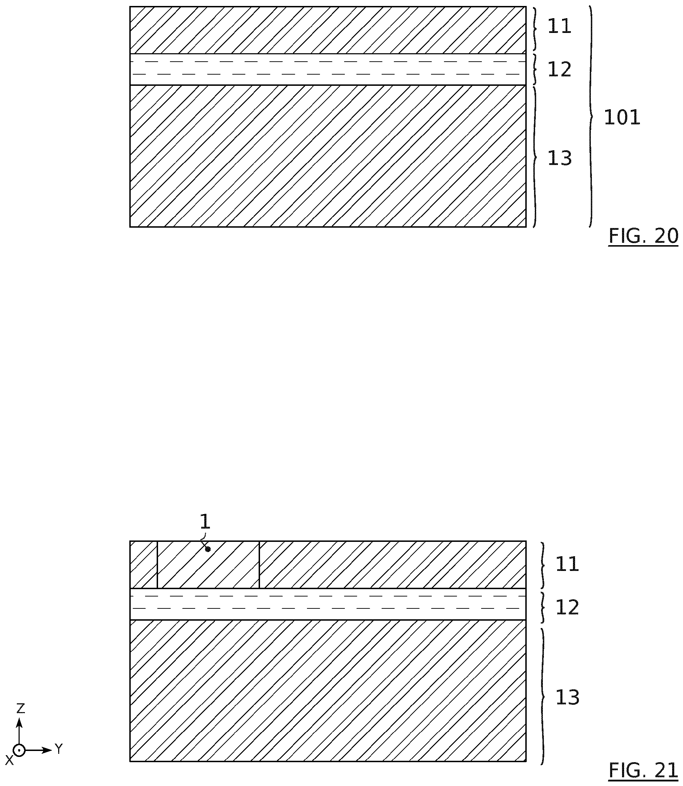

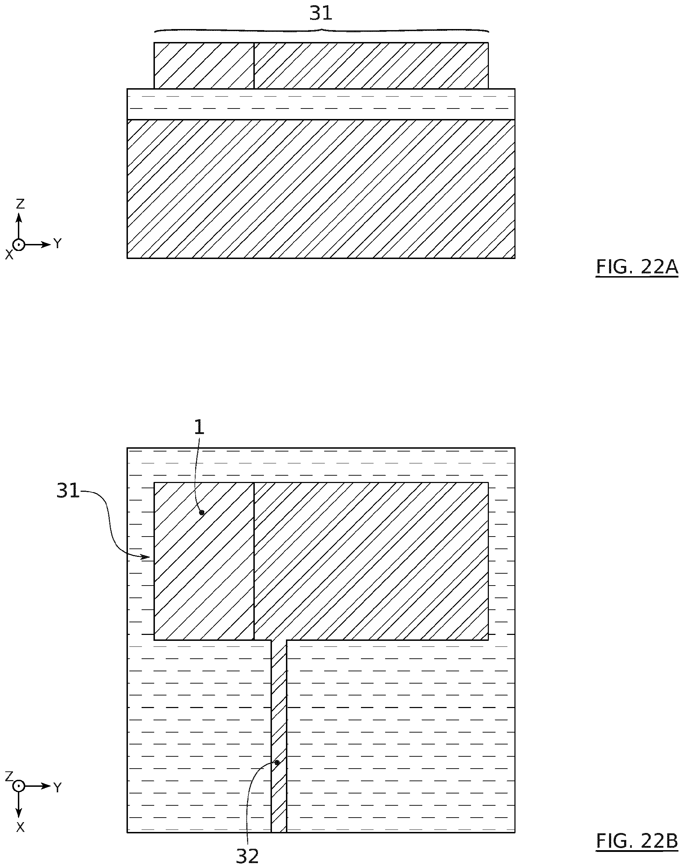

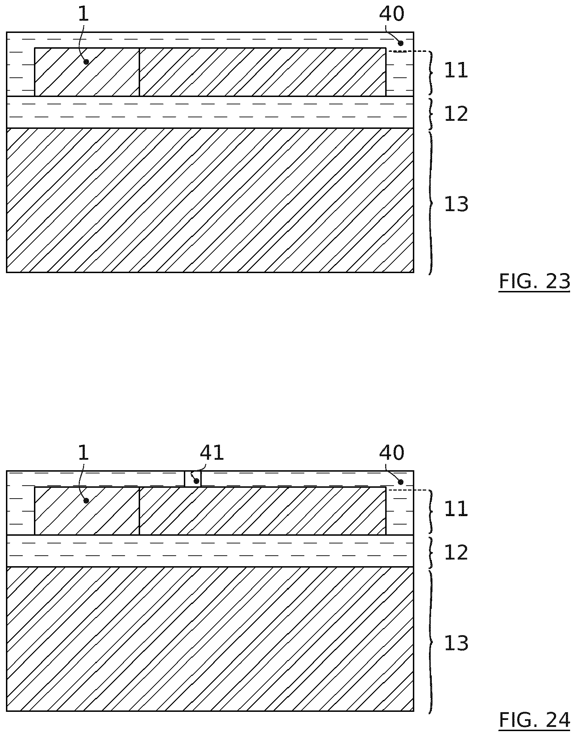

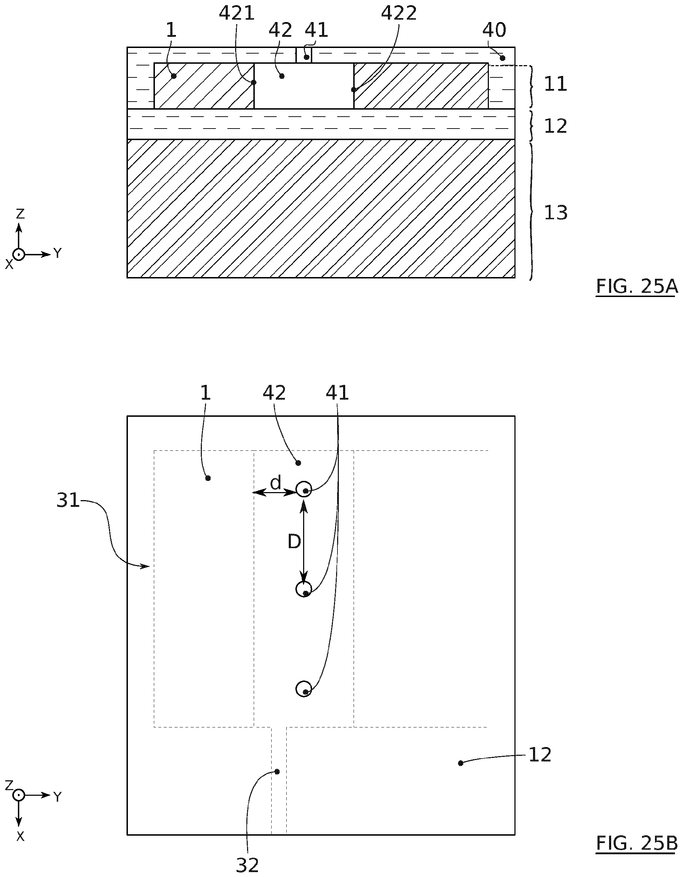

Un deuxième mode de réalisation du procédé selon l'invention va maintenant être décrit en référence aux figures 20 à 29. La photodiode obtenue par ce deuxième mode de réalisation est une photodiode à avalanche latérale GeOI à double hétérojonction.

Seules les caractéristiques distinctes du premier mode de réalisation sont décrites ci-après, les autres caractéristiques non décrites étant réputées identiques à celles du premier mode de réalisation décrit ci-dessus en référence aux figures 4 à 19B.

Les premières étapes de ce deuxième mode de réalisation, illustrées aux figures 20 à 27, consistant essentiellement à former la première zone de contact 1, définir les premier et deuxième motifs 31, 32, les encapsuler, former les ouvertures 41 et la cavité 42, faire les première et deuxième épitaxies de Si-i puis de Si-p, et remplir 124 la cavité 42 par épitaxie latérale de germanium sont des étapes communes avec le premier mode de réalisation.

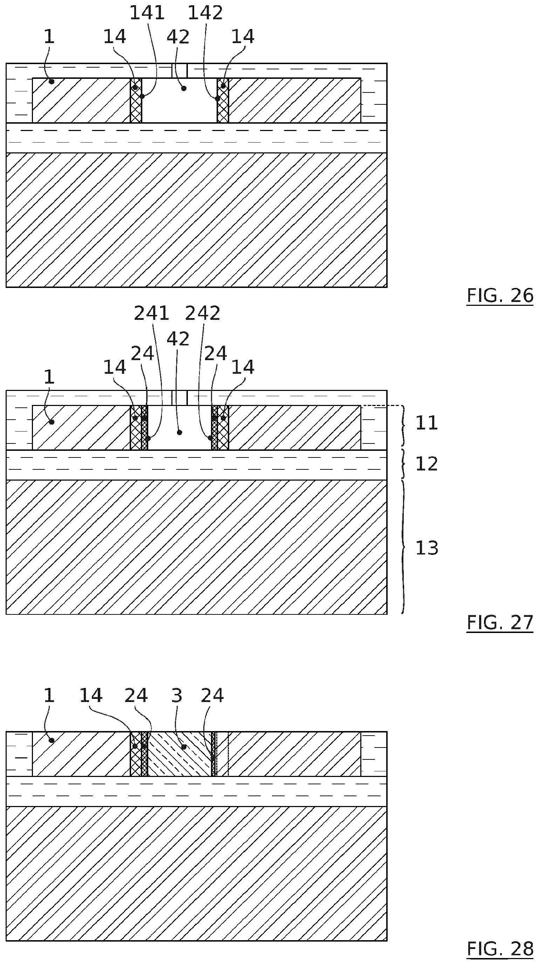

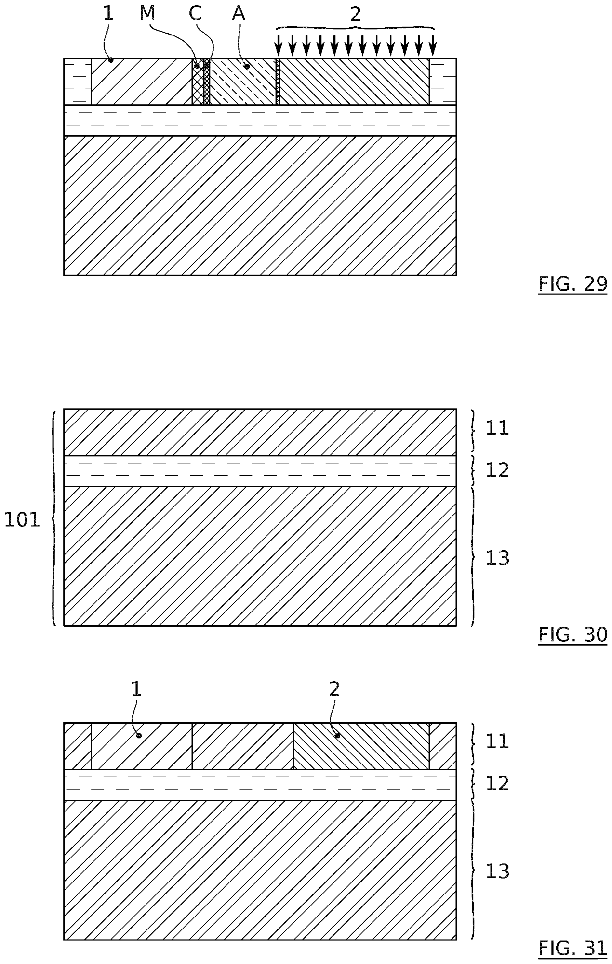

Dans ce deuxième mode de réalisation, de préférence après remplissage de la cavité 42 et planarisation (figure 28), la formation 120b de la deuxième zone de contact 2 est réalisée par implantation ionique directement en bordure de la cavité 42 remplie de germanium 3, sur un côté opposé à la première zone de contact 1 (figure 29).

L'implantation ionique peut être avantageusement configurée pour effectuer un dopage p++ du silicium du top Si 11, du silicium Si-i de la première couche 14 et d'une partie au moins du silicium Si-p de la deuxième couche 24 en bordure de la cavité 42 remplie.

La deuxième zone de contact 2 recouvre ainsi de préférence la zone de multiplication M et une partie au moins de la zone de charge C de sorte à former latéralement une photodiode à avalanche latérale GeOI en configuration SACM à double hétérojonction (figure 29).

Cette photodiode peut présenter avantageusement selon y la succession de matériaux suivante :
Un silicium dopé n++ (première zone de contact 1), un silicium intrinsèque (zone de multiplication M), un silicium dopé p+ (zone de charge C), un germanium intrinsèque (zone d'absorption A), un silicium dopé p+ résiduel, un silicium dopé p++ (deuxième zone de contact 2).

Ces matériaux sont de préférence intercalés selon z entre le BOX 12 en SiO2 et une couche d'oxyde SiO2.

La photodiode obtenue présente avantageusement un confinement optique de la zone d'absorption A amélioré, et une sensibilité de détection de la lumière accrue.

Un troisième mode de réalisation du procédé selon l'invention illustré aux figures 30 à 39 vise à obtenir une photodiode p-i-n latérale à double hétérojonction issue d'un premier substrat 101 et reportée sur un deuxième substrat 102.

Selon ce troisième mode de réalisation, le premier substrat 101 est de préférence un substrat SOI (figure 30).

Les première et deuxième zones de contact 1, 2 n++ et p++ sont formées dans le top Si 11, de préférence par implantation ionique. Les première et deuxième zones de contact 1, 2 présentent de préférence des largeurs d'environ 15 µm.

Une zone de top Si 11 non implantée et intercalée selon y entre les première et deuxième zones de contact 1, 2 présente de préférence une largeur de l'ordre de 1 µm (figure 31).

Les premier et deuxième motifs 31, 32 peuvent être ensuite définis et encapsulés comme précédemment.

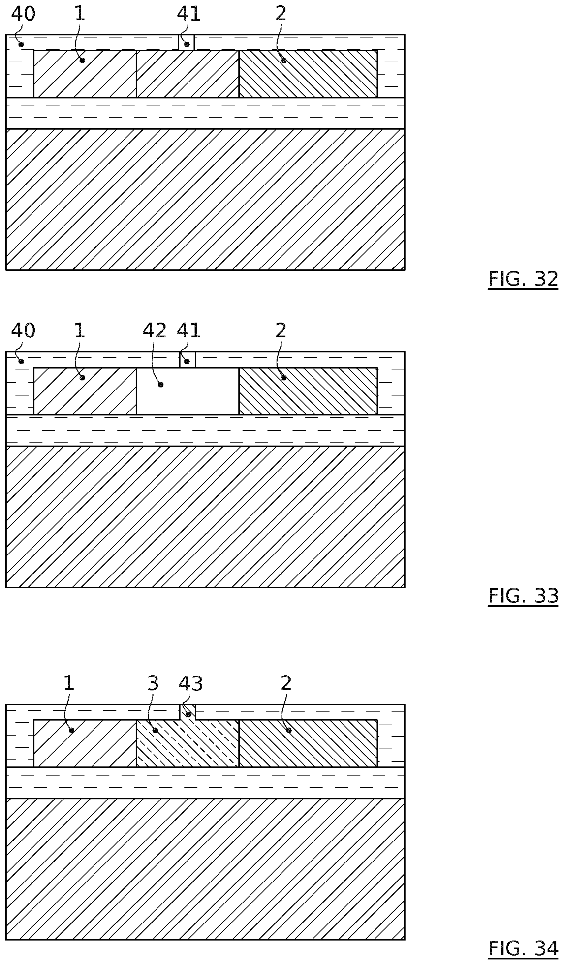

Les ouvertures 41 sont formées dans la couche d'encapsulation 40 de façon à être centrées selon y sur la zone non implantée (figure 32).

La zone non implantée est ensuite gravée de manière à former une cavité 42 s'étendant entre les première et deuxième zones de contact 1, 2 (figure 33).

La cavité 42 peut être remplie par épitaxie latérale de germanium 3 selon les mêmes conditions de remplissage que celles exposées précédemment dans les autres modes de réalisation de l'invention (figure 34).

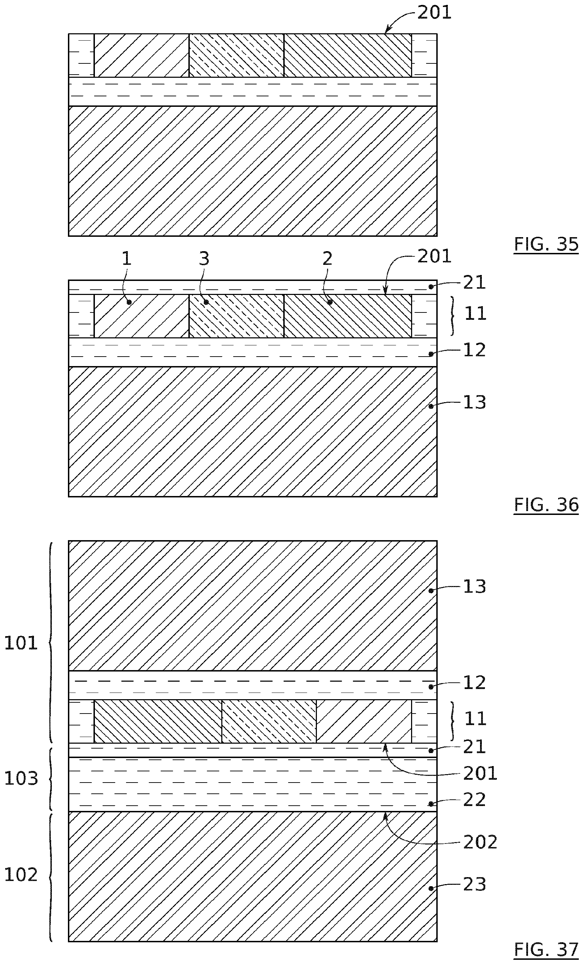

Une étape de planarisation permettant d'éliminer les excroissances 43 de germanium 3 est de préférence réalisée, exposant une face 201 plane de la structure p-i-n (figure 35).

Un dépôt d'une couche 21 d'oxyde SiO2, par exemple un dépôt CVD à partir d'un précurseur TEOS (« tetraethylorthosilicate » en anglais, ou orthosilicate de tétraéthyle), est effectué, de préférence pleine plaque, sur la face 201 planarisée (figure 36). Cette couche d'oxyde 21 peut présenter une épaisseur comprise entre quelques dizaines de nanomètres et quelques microns.

Un collage direct entre ces premier et deuxième substrats 101, 102 est de préférence effectué.

Le deuxième substrat 102 peut être par exemple un substrat de silicium 23 comprenant éventuellement des dispositifs optoélectroniques ou microélectroniques sur une face 202. Ce deuxième substrat 102 peut également comprendre des matériaux III-V et/ou des dispositifs de type photonique sur silicium.

Un dépôt d'oxyde, par exemple par CVD à partir d'un précurseur TEOS ou par oxydation thermique, peut être réalisé sur la face 202 du deuxième substrat 102 de sorte à former une couche d'oxyde 22 d'épaisseur comprise entre quelques centaines de nanomètres et quelques microns.

Une étape de préparation de surface des faces 201, 202 des premier et deuxième substrats 101, 102, comprenant par exemple un nettoyage et une hydrolyse, est de préférence réalisée. Le nettoyage peut être réalisé par exemple dans un bain d'eau désionisée enrichie en ozone. L'hydrolyse peut être réalisée par exemple dans une solution de peroxyde d'ammonium (APM pour l'acronyme anglais « Ammonium peroxide mixture ») à 70°C.

Après préparation des surfaces, la face 201 comprenant l'oxyde 21 du premier substrat 101 est mise en contact avec la face 202 comprenant l'oxyde 22 du deuxième substrat 102, à température et pression ambiantes.

Un recuit à 400°C pendant deux heures peut ensuite être effectué de manière à finaliser le collage direct 103 par adhésion moléculaire entre les oxydes 21, 22 (figure 37).

Par exemple, selon une possibilité, un deuxième substrat 102 à base de matériaux III-V et de préférence à base de GaN peut être directement collé sur la couche d'oxyde 21 du premier substrat 101. Après collage, ce deuxième substrat 102 peut dès lors être traité ou transformé par une série d'étapes technologiques de manière à réaliser des dispositifs et/ou des composants photoniques.

Une puce comprenant au moins une photodiode p-i-n latérale GeOI à double hétérojonction et des composants photoniques à base de GaN peut ainsi être avantageusement réalisée.

Selon une autre possibilité le premier substrat 101 peut être retourné et reporté sur un deuxième substrat 102, par exemple en silicium.

Le Si bulk 13 du premier substrat 101 peut ensuite être retiré, par exemple par rognage et abrasion sur au moins 95 % de son épaisseur initiale puis par gravure sélective dans une solution à base d'hydroxyde de tetramethylammonium (TMAH), de sorte à exposer le BOX 12.

Cette possibilité permet d'obtenir en surface une couche d'oxyde d'épaisseur très bien contrôlée formée par le BOX 12 exposé. Certains composants photoniques nécessitant une telle couche d'oxyde d'épaisseur très bien contrôlée peuvent dès lors être formés sur le BOX 12 exposé. Par exemple, un modulateur capacitif comprenant des électrodes de part et d'autre du BOX 12 d'épaisseur très bien contrôlée peut avantageusement être formé. Un tel modulateur peut en effet présenter une précision améliorée sur les valeurs de la capacité. Son fonctionnement peut ainsi être avantageusement optimisé.

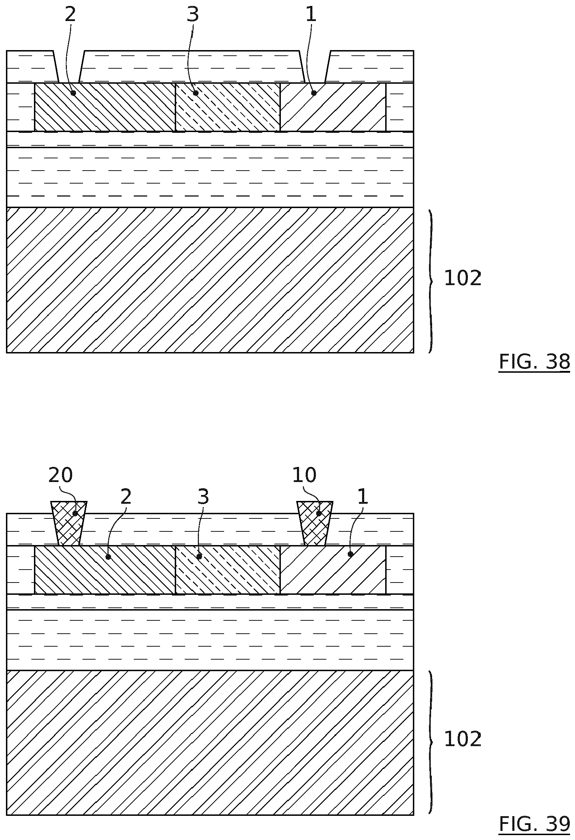

Des vias traversants au niveau des première et deuxième zones de contact 1, 2 de la photodiode peuvent ensuite être formés (figure 38), et des contacts métalliques 10, 20 peuvent ensuite être déposés au niveau des vias puis activés (figure 39).

Avantageusement, les contacts métalliques 10, 20 présentent des surfaces métalliques en affleurement des première et deuxième zones de contact 1, 2, dans un plan définissant une nouvelle bordure supérieure de la zone d'absorption A. Le transport de charges et/ou le confinement optique d'une telle photodiode p-i-n latérale est amélioré par rapport à une solution nécessitant de graver des vias au travers d'une couche de germination 111.

Une photodiode p-i-n latérale GeOI à double hétérojonction reportée sur un deuxième substrat 102 peut ainsi être réalisée (figure 39).

Une puce comprenant au moins une photodiode p-i-n latérale GeOI à double hétérojonction sur une première face du BOX 12, et par exemple au moins un modulateur capacitif en partie sur une deuxième face du BOX 12 opposée à la première face peut ainsi être avantageusement obtenue.

Le procédé selon l'invention permet d'obtenir des photodiodes latérales p-i-n GeOI et des photodiodes latérales à avalanche GeOI.

De telles photodiodes constituent également un aspect séparable de l'invention.

L'invention n'est pas limitée aux modes de réalisations précédemment décrits et s'étend à tous les modes de réalisation couverts par les revendications.

## Revendications

1. Procédé de réalisation d'une photodiode comprenant une première zone de contact (1), une deuxième zone de contact (2) et une zone d'absorption (A) juxtaposées de sorte à s'étendre parallèlement suivant une première direction (x), ladite zone d'absorption (A) étant située entre les première et deuxième zones de contact (1, 2) selon une deuxième direction (y), ledit procédé comprenant les étapes suivantes :
- Fournir un premier substrat (101) comprenant un empilement selon une troisième direction (z) d'une première couche (11) à base d'un premier matériau sur une deuxième couche (12) à base d'un deuxième matériau différant du premier matériau,
- Former au niveau de la première couche (11) la première zone de contact (1),
- Former au niveau de la première couche (11) la deuxième zone de contact (2),
- Former au niveau de la première couche (11) la zone d'absorption (A),
ledit procédé étant **caractérisé en ce que** la formation de la zone d'absorption (A) comprend au moins les étapes successives suivantes :
• Encapsuler la première couche (11), au moins dans une zone correspondant à la zone d'absorption (A), par une couche d'encapsulation (40),
• Former au moins une ouverture (41) au travers de la couche d'encapsulation (40) de sorte à exposer une zone de la première couche (11),
• Former une cavité (42) au moins au niveau de la zone d'absorption (A), ladite formation comprenant un retrait du premier matériau sur toute l'épaisseur de la première couche (11) au travers de l'au moins une ouverture (41), la cavité (42) comprenant une face inférieure (424) à base du deuxième matériau de la deuxième couche (12), une face supérieure (423) formée par une partie de la couche d'encapsulation (40) et une pluralité de parois latérales (421, 422) s'étendant selon la troisième direction (z), ladite pluralité comprenant au moins une paroi latérale (421) à base du premier matériau s'étendant selon la première direction (x) en bordure de l'une parmi les première et deuxième zones de contact (1, 2),
• Remplir au travers de l'au moins une ouverture (41) la cavité (42) avec un troisième matériau (3) de remplissage par une croissance épitaxiale latérale dudit matériau (3) au moins à partir de l'au moins une paroi latérale (421) de la cavité (42), la croissance étant principalement dirigée selon la deuxième direction (y).

2. Procédé selon la revendication précédente dans lequel la pluralité de parois latérales (421, 422) de la cavité (42) forme un contour fermé.

3. Procédé selon l'une quelconque des revendications précédentes dans lequel la formation de l'au moins une ouverture (41) est configurée de sorte à ce que la zone exposée de la première couche (11) soit située en dehors de la zone d'absorption (A), de préférence à une distance supérieure à 1 µm de la zone d'absorption (A).

4. Procédé selon l'une quelconque des revendications précédentes dans lequel les premier et troisième matériaux présentent chacun une structure cristallographique de type cubique, et dans lequel la première direction (x) correspond à une orientation cristallographique de type [100], la deuxième direction (y) correspond à une orientation cristallographique de type [010], et la troisième direction (z) correspond à une orientation cristallographique de type [001].

5. Procédé selon l'une quelconque des revendications précédentes comprenant en outre, lors de la formation de la cavité après retrait du premier matériau (S), l'étape suivante :
- Former, sur au moins une paroi latérale (121, 122) bordant l'une au moins parmi les première et deuxième zones de contact (1, 2), une première couche latérale (14) en un matériau à base du premier matériau mais différent du premier matériau, destinée à former une couche de multiplication (M) de la photodiode,
procédé dans lequel la formation de la première couche latérale (14) se fait par une croissance épitaxiale latérale principalement selon la deuxième direction (y).

6. Procédé selon l'une quelconque des deux revendications précédentes comprenant en outre, après la formation de la première couche latérale (14), l'étape suivante :
- Former, sur au moins une paroi latérale (141, 142) de la première couche latérale (14), une deuxième couche latérale (24) à base du premier matériau mais différent du premier matériau et du matériau de la première couche latérale (14), destinée à former une couche de charge (C) de la photodiode, procédé dans lequel la formation de la deuxième couche latérale (24) se fait par une croissance épitaxiale latérale principalement selon la deuxième direction (y).

7. Procédé selon l'une quelconque des revendications précédentes dans lequel le premier substrat (101) comprend une troisième couche (13), de sorte que la deuxième couche (12) soit intercalée entre les première et troisième couches (11, 13) selon la troisième direction (z), le procédé comprenant en outre une séquence d'étapes de retournement de la photodiode sur un deuxième substrat (102), ladite séquence comprenant les étapes suivantes :
- Fournir un deuxième substrat (102),
- Coller par adhésion moléculaire le deuxième substrat (102) au premier substrat (101) selon la troisième direction (z), la première couche (11) du premier substrat (101) étant tournée en regard du deuxième substrat (102),
- Retirer la troisième couche (13) du premier substrat (101).

8. Procédé selon l'une quelconque des revendications précédentes comprenant en outre une formation au niveau de la couche supérieure (11) d'un guide d'onde (30) en couplage direct avec la zone d'absorption (A).

9. Procédé selon l'une quelconque des revendications précédentes dans lequel l'au moins une ouverture (41) présente un contour fermé et est distante de la première zone de contact (1) d'une distance d selon la deuxième direction (y) telle que 0.6 µm < d < 1.5 µm et de préférence 1.1 µm < d < 1.5 µm.

10. Procédé selon l'une quelconque des revendications précédentes dans lequel la croissance épitaxiale latérale du matériau (3) de remplissage se fait à une première température T1 pendant un premier temps t1 tels que 400°C < T1 < 450°C et 1 min < t1 < 20 min, puis à une deuxième température T2 comprise entre 600°C et 750°C pendant un deuxième temps t2 choisi de manière à remplir toute la cavité (42).

11. Procédé selon l'une quelconque des revendications précédentes dans lequel le retrait du premier matériau lors de la formation de la cavité (42) se fait par gravure, ladite gravure étant configurée pour produire une vitesse de gravure au moins 25 % plus grande dans des directions cristallographiques [110] et [1-10] que dans des directions cristallographiques [010] et [100] du premier matériau (S) de la première couche (11), et de préférence au moins 35 % plus grande.

12. Procédé selon l'une quelconque des revendications précédentes dans lequel le premier matériau est du silicium, le deuxième matériau est un matériau diélectrique tel qu'un oxyde de silicium, et le troisième matériau (3) est du germanium.

13. Procédé selon l'une quelconque des revendications précédentes comprenant en outre une formation d'une cavité supplémentaire (42b) juxtaposée à la cavité (42) et s'étendant parallèlement à celle-ci selon la première direction (x), ladite formation comprenant les étapes suivantes :
- Encapsuler la première couche (11), au moins dans une zone juxtaposant la cavité (42), par une couche d'encapsulation (40, 40b),
- Former au moins une ouverture supplémentaire (41b) au travers de la couche d'encapsulation (40, 40b) de sorte à exposer une zone de la première couche (11) au niveau de la zone juxtaposant la cavité (42),
- Retirer le premier matériau sur toute l'épaisseur de la première couche (11) au travers de l'au moins une ouverture supplémentaire (41b),
ladite cavité supplémentaire (42b) comprenant une face inférieure (424b) à base du deuxième matériau de la deuxième couche (12), une face supérieure (423b) formée par une partie de la couche d'encapsulation (40, 40b) et une pluralité de parois latérales (421b, 422b) s'étendant selon la troisième direction (z), ladite pluralité comprenant au moins une paroi latérale (421b) à base du premier matériau s'étendant selon la première direction (x) en bordure de la cavité (42), la cavité supplémentaire étant de préférence formée après remplissage de la cavité (42).

14. Procédé selon la revendication précédente, dans lequel la formation de la cavité supplémentaire (42b) est configurée de sorte à ce que ladite cavité supplémentaire (42b) soit séparée de la cavité (42) selon la deuxième direction (y) par une couche à base du premier matériau présentant une dimension selon ladite deuxième direction (y) inférieure ou égale à 50 nm.

15. Procédé selon l'une quelconque des revendications 13 à 14 comprenant en outre, après formation de la cavité supplémentaire (42b), un remplissage de ladite cavité supplémentaire (42b) au travers de l'au moins une ouverture supplémentaire (41b) avec le troisième matériau (3) de remplissage par une croissance épitaxiale latérale dudit matériau (3) au moins à partir de l'au moins une paroi latérale (421b) de la cavité supplémentaire (42b), la croissance étant principalement dirigée selon la deuxième direction (y),
procédé de préférence dans lequel la formation de l'une parmi les première et deuxième zones de contact (1, 2) se fait par implantation ionique en partie au moins au niveau de la cavité supplémentaire (42b) après remplissage de celle-ci.

16. Photodiode comprenant une première zone de contact (1) et une deuxième zone de contact (2) formées dans une première couche (11) à base d'un premier matériau, ainsi qu'une zone d'absorption (A) localisée dans une cavité (42) située dans la première couche (11), la première zone de contact (1), la deuxième zone de contact (2) et la zone d'absorption (A) étant juxtaposées de sorte à s'étendre parallèlement suivant une première direction (x), ladite zone d'absorption (A) étant située entre les première et deuxième zones de contact (1, 2) selon une deuxième direction (y), la première couche (11) étant au contact d'une deuxième couche (12) à base d'un deuxième matériau différant du premier matériau, selon une troisième direction (z) perpendiculaire aux première et deuxième directions (x, y), ladite zone d'absorption (A) étant configurée pour confiner de la lumière, le premier matériau étant du silicium, le deuxième matériau étant un diélectrique, le troisième matériau étant du germanium, la photodiode étant **caractérisée en ce que** la zone d'absorption (A) est formée sur toute une épaisseur de la première couche (11) et comprend un troisième matériau (3) différant des premier et deuxième matériaux et directement au contact du deuxième matériau de la deuxième couche (12).
